# EUROPEAN PATENT APPLICATION

(11) **EP 4 432 510 A1**
(43) Date of publication of application: **18.09.2024**
(21) Application number: 21964097.6
(22) Date of filing: 12.11.2021
(51) Int. Cl.: H02J 7/00

(54) **CHARGE CONTROL METHOD AND CHARGE CONTROL DEVICE**

(71) Applicant: Nissan Motor Co., Ltd., Yokohama-shi, Kanagawa 221-0023 (JP)
(72) Inventor: TANIGUCHI, Ikuhiro, Atsugi-shi, Kanagawa 243-0123 (JP); IGUCHI, Toyoki, Atsugi-shi, Kanagawa 243-0123 (JP); SANO, Hiroyuki, Atsugi-shi, Kanagawa 243-0123 (JP); KOBAYASHI, Azusa, Atsugi-shi, Kanagawa 243-0123 (JP); SHIBUI, Hiroyuki, Atsugi-shi, Kanagawa 243-0123 (JP)
(74) Representative: Grünecker Patent- und Rechtsanwälte PartG mbB
(86) International application number: PCT/JP2021/041755
(87) International publication number: WO 2023/084742

(57) **Abstract**

A charge control method according to an embodiment controls charge of a battery that includes a lithium-ion battery and is disposed in a vehicle and: calculates a long-term chargeable power as a power that allows charging the battery for a long term; calculates a short-term chargeable power as a power that allows charging the battery for a short term and is larger than the long-term chargeable power; calculates a continuous chargeable power that allows continuously charging the battery based on the short-term chargeable power and the long-term chargeable power; and restricts an upper limit of a charge power of the battery 1 to the continuous chargeable power.

## Description

### Technical Field

The present invention relates to a charge control method and a charge control device of a battery including a lithium-ion battery.

### Background Art

There has been known a charge/discharge control method of a secondary battery that determines such that when a temperature of a battery is a predetermined temperature or less or the predetermined temperature or more, a charge power upper limit value Pin-s and a discharge power upper limit value Pout-s are smaller than those at an ordinary temperature, detects the temperature of the battery, determines charge power and discharge power so as to be the charge/discharge power upper limit values Pin-s, Pout-s or less at the detected temperature, and performs charge control of the battery (for example, Patent Document 1).

### Prior Art Document

### Patent Document

Patent Document 1: Japanese Unexamined Patent Application Publication No. 2003-219510

### Summary of Invention

### Problems to Be Solved by Invention

However, when charge of a battery of a vehicle is controlled by the above-described conventional control method by the charge control device, there is a problem that an upper limit of a chargeable power set at a low temperature of the battery lowers and absorbing a power generated according to a running scene of a vehicle by the battery is difficult.

A problem to be solved by the present invention is to provide a charge control method and a charge control device that allow absorbing a power generated according to a running scene of a vehicle by a battery.

### Means for Solving Problems

The present invention solves the above-described problem by: calculating a long-term chargeable power; calculating a short-term chargeable power larger than the long-term chargeable power; calculating a continuous chargeable power based on the short-term chargeable power and the long-term chargeable power; and restricting an upper limit of a charge power of the battery to the continuous chargeable power.

### Effects of Invention

According to the present invention, a power generated according to a running scene of a vehicle can be absorbed by the battery.

### Brief Description of Drawings

FIG. 1 is a block diagram illustrating a drive system according to one embodiment of the present invention.
FIG. 2(a) is a graph illustrating voltage characteristics of a battery, and FIG. 2(b) is a graph illustrating charge power characteristics of the battery.
FIG. 3 is a graph illustrating response characteristics of a short-term chargeable power, an intermediate-term chargeable power, and a long-term chargeable power.
FIG. 4 is a block diagram illustrating a function block of a chargeable power calculation unit.
FIG. 5 is a graph illustrating characteristics of short-term/long-term chargeable powers, a target maintaining power, an actual charge power, and a continuous chargeable power.
FIG. 6 is a flowchart of a charge control method according to the embodiment.
FIG. 7 is a block diagram illustrating a drive system according to another embodiment of the present invention.
FIG. 8 is a table for describing a correlation between a battery temperature, an SOC, the short-term chargeable power, and the target maintaining power.
FIG. 9 is a conceptual diagram of a map stored in an upper limit SOC calculation unit.
FIG. 10 is a block diagram illustrating a control flow of a calculation method of the upper limit SOC by the upper limit SOC calculation unit.
FIG. 11 is a flowchart of a charge control method in another embodiment of the present invention.
FIG. 12 is a block diagram illustrating a drive system according to another embodiment of the present invention.
FIG. 13 is a block diagram illustrating a control flow of a warming-up determination method by a warming-up determination unit.
FIG. 14 is a timing chart of various parameters related to warming-up determination and a warming-up determination result, FIG. 14(a) illustrates a timing chart at a cryogenic temperature and FIG. 14(b) illustrates a timing chart at a low temperature.
FIG. 15 is a flowchart of a charge control method in another embodiment of the present invention.

### Mode(s) for Carrying out the Invention

### «First Embodiment»

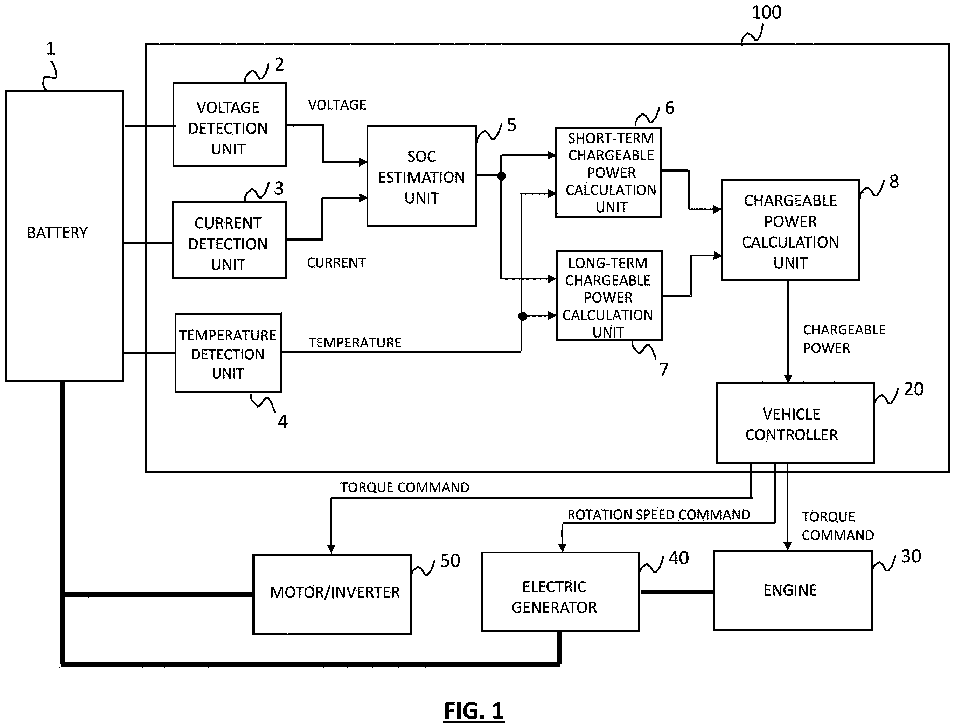

The following describes one embodiment of a charge control system according to the present invention with reference to the drawings. FIG. 1 is a block diagram illustrating a drive system according to one embodiment of the present invention. The drive system is a drive system of a hybrid vehicle and includes a battery 1, an engine 30, an electric generator 40, a motor/inverter 50, and a charge control device 100. A battery charge/discharge control system according to the embodiment is a part of the drive system and controls a discharge power supplied from the battery 1 to the motor 50 and a charge power that charges the battery 1 by a generated power of the electric generator 40. A charge control method and a charge control device according to the embodiments mainly relate to control during charging the battery 1, and hereinafter the charge control of the battery 1 is mainly described.

The battery 1 is a power source disposed in the hybrid vehicle and includes a plurality of lithium-ion batteries. The lithium-ion battery charges and discharges by movement of lithium ions between a positive electrode and a negative electrode. The engine 30, the electric generator 40, and the motor 50 constitute a drive system of a series hybrid, the engine 30 is used to drive the electric generator 40, and the power generated by the electric generator 40 is supplied to the battery 1 to charge the battery 1. At this time, the charge control device 100 controls a rotation speed of the electric generator 40 to control the charge power supplied from the electric generator 40 to the battery 1. The motor/inverter 50 includes an inverter that converts a voltage output from the battery 1 from a direct current into an alternate current and a motor that drives at the converted alternate voltage.

The charge control device 100 is a control unit (processor) that controls the charge power of the battery 1 while managing a State of Charge (SOC) of the battery 1. The charge control device 100 includes a voltage detection unit 2, a current detection unit 3, a temperature detection unit 4, an SOC estimation unit 5, a short-term chargeable power calculation unit 6, a long-term chargeable power calculation unit 7, a chargeable power calculation unit 8, and a vehicle controller 20.

The voltage detection unit 2, the current detection unit 3, and the temperature detection unit 4 are units that detect a state inside the battery 1, and detect a voltage of each cell included in the battery 1, a current flowing through each cell, and a temperature inside a battery pack by a voltage sensor, a current sensor, and a temperature sensor of the battery 1.

The SOC estimation unit 5 estimates the SOC of the battery 1 based on the battery voltage detected by the voltage detection unit 2 and/or the battery current detected by the current detection unit 3. The SOC estimation unit 5 has an SOC-OCV map in which an OCV is made correspond to the SOC of the battery 1. The SOC estimation unit 5 acquires a voltage in an unloaded state (OCV) of the battery 1 from the voltage detection unit 2 at a start of a vehicle, refers to the SOC-OCV map, and sets an initial SOC. The SOC estimation unit 5 integrates the current after the start of the vehicle and adds a current integrated value to the initial SOC to estimate an SOC after the start.

The short-term chargeable power calculation unit 6 calculates a short-term chargeable power based on the SOC of the battery 1 and a temperature of the battery 1 (battery temperature). The short-term chargeable power is a power that allows charging the battery 1 for a short term. The short-term chargeable power is equivalent to a power generated by overshooting of an engine rotation speed after the start of the engine 30 or a power that allows absorbing a regenerative charge power during running a vehicle (especially at a high speed). Note that a time to determine the short-term chargeable power is in a range from several seconds to several tens of seconds or less, is determined by, for example, a time from the engine start until the overshooting of the engine rotation speed and/or a time in which the large regenerative power generated during vehicle deceleration is absorbed by the battery 1, and is at least shorter than a range of a time to determine a long-term chargeable power described later.

The short-term chargeable power calculation unit 6 calculates an upper limit current at which lithium is not deposited based on the temperature of the battery 1 and the SOC estimated by the SOC estimation unit 5. The upper limit current indicates a current upper limit value at which lithium is not deposited when the battery 1 is charged for a short time. The short time corresponds to a short term in the short-term chargeable power. The upper limit current is a value determined from the temperature of the battery 1 and the SOC, and the lower the battery temperature is or the higher the SOC is, the smaller the upper limit current is. The upper limit current is a value experimentally determined according to characteristics of the battery 1 or the like. The short-term chargeable power calculation unit 6 has a map in which the temperature of the battery 1, the SOC, and the upper limit current correspond to one another, and calculates the upper limit current by map calculation using the temperature of the battery 1 and the SOC as inputs.

Next, the short-term chargeable power calculation unit 6 calculates an internal resistance of the battery 1. The short-term chargeable power calculation unit 6 refers to the map and calculates the internal resistance with the temperature of the battery 1 and the SOC as inputs. Alternatively, the short-term chargeable power calculation unit 6 may calculate the internal resistance from the voltage of the battery 1 and a charge/discharge current during running the vehicle in a stable state of the voltage of the battery 1. Note that the calculation method of the internal resistance may be another well-known method.

The short-term chargeable power calculation unit 6 calculates a voltage increased by the internal resistance when the upper limit current is flowed to the battery 1 (upper limit current × internal resistance). Furthermore, the short-term chargeable power calculation unit 6 adds the calculated voltage (upper limit current × internal resistance) to the OCV corresponding to the SOC of the battery 1 to calculate a voltage when the battery 1 is charged at the upper limit current (voltage during charging the upper limit current). The short-term chargeable power calculation unit 6 multiplies the voltage during charging the upper limit current by the upper limit current to calculate a short-term chargeable power (Pₛ₁). Thus, the short-term chargeable power calculation unit 6 calculates the short-term chargeable power (Pₛ₁) based on the upper limit current.

In addition to the short-term chargeable power (Pₛ₁), the short-term chargeable power calculation unit 6 calculates a short-term chargeable power (Pₛ₂) that does not exceed the upper limit voltage usable of the battery. The short-term chargeable power (Pₛ₁) is a short-term chargeable power based on the upper limit current at which lithium is not deposited, and the short-term chargeable power (Pₛ₂) is a short-term chargeable power based on the upper limit voltage of a battery usable voltage range. For the battery 1, the usable voltage is preliminarily determined to avoid excessive discharge and overcharge, and the charge control device 100 controls the charge/discharge of the battery 1 such that the voltage of the battery 1 falls within the usable voltage range.

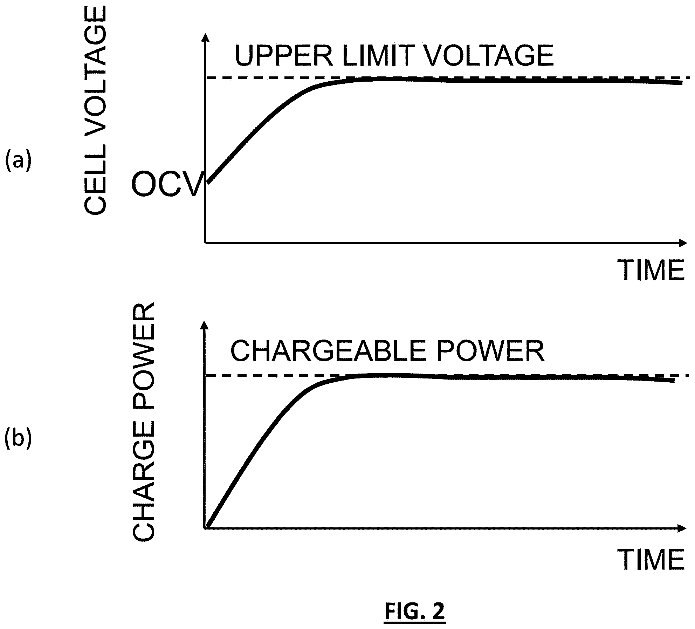

FIG. 2(a) is a graph illustrating characteristics of a voltage of the battery 1 (cell voltage), and FIG. 2(b) is a graph illustrating characteristics of a charge power of the battery 1. The horizontal axis of FIG. 2 is a time, and respective vertical axes are the cell voltage and the charge power. When the battery 1 is charged, the voltage of the battery 1 increases from the OCV by the internal resistance and transitions at the characteristics of FIG. 2(a).

The short-term chargeable power calculation unit 6 calculates the short-term chargeable power (Pₛ₂) when the voltage of the battery 1 matches the upper limit voltage of the usable voltage range by the following formula (1). In the formula (1), the internal resistance is an internal resistance value in a short term, and, for example, it is only necessary to be calculated based on, for example, the temperature of the battery and/or a deterioration rate. It is only necessary that the OCV is calculated from the SOC-OCV map.
[Math. 1] Short-term chargeable power [Ps2] = (upper limit voltage - OCV)/internal resistance × upper limit voltage

Thus, the short-term chargeable power calculation unit 6 calculates the short-term chargeable power [Pₛ₂] that does not exceed the upper limit voltage based on the temperature of the battery 1 and the SOC.

After calculating the short-term chargeable power (Pₛ₁) and the short-term chargeable power (Pₛ₂), the short-term chargeable power calculation unit 6 finally calculates the smaller power as the short-term chargeable power. Thus, while the charge control device 100 according to the embodiment reduces the deposition of lithium, the charge control device 100 can control the charge of the battery 1 so as not to exceed the upper limit voltage of the battery usable voltage range. Note that the short-term chargeable power calculation unit 6 does not necessarily need to calculate both powers of the short-term chargeable power (Pₛ₁) and the short-term chargeable power (Pₛ₂), and may calculate any one of the short-term chargeable powers. For example, as long as the battery 1 is used within a setting range of the usable voltage range or the battery 1 is used at the cell voltage within the usable voltage range according to a usage environment of the battery 1 or the like, when the deposition of the lithium can be reduced, the short-term chargeable power calculation unit 6 only needs to calculate at least the short-term chargeable power (Pₛ₂).

The long-term chargeable power calculation unit 7 calculates the long-term chargeable power based on the SOC of the battery 1 and the temperature of the battery 1. The long-term chargeable power is a power that can charge the battery 1 for a long term. The long-term chargeable power is equivalent to a chargeable power required to complete warming-up of the battery 1 by charge. Note that the time to determine the long-term chargeable power is a time within a range from several hundreds of seconds to several tens of minutes.

The long-term chargeable power calculation unit 7 calculates the upper limit current at which the lithium is not deposited based on the temperature of the battery 1 and the SOC estimated by the SOC estimation unit 5, and calculates the long-term chargeable power (P_{L1}) based on the upper limit current. A calculation method of the long-term chargeable power (P_{L1}) is similar to the calculation method of the short-term chargeable power (P_{L1}) by the short-term chargeable power calculation unit 6. However, the upper limit current is an upper limit current at which the lithium is not deposited when the battery 1 is charged for a long time. The internal resistance of the battery 1 is an internal resistance value for long term and is calculated with reference to the map.

Next, in addition to the long-term chargeable power (P_{L1}), the long-term chargeable power calculation unit 7 calculates the long-term chargeable power (P_{L2}) that does not exceed the usable upper limit voltage of the battery. The long-term chargeable power (P_{L1}) is a long-term chargeable power based on the upper limit current at which the lithium is not deposited, and the long-term chargeable power (P_{L2}) is a long-term chargeable power based on the upper limit voltage of the battery usable voltage range. A calculation method of the long-term chargeable power (P_{L2}) is similar to the calculation method of the short-term chargeable power (Pₛ₂) by the short-term chargeable power calculation unit 6 and the operation expression is also similar to the formula (1). However, the internal resistance of the battery 1 is an internal resistance value for a long term, and, for example, it is only necessary to be calculated based on, for example, the temperature of the battery and/or the deterioration rate. It is only necessary that the OCV is calculated from the SOC-OCV map. Thus, a long-term chargeable power calculation unit 7 calculates the long-term chargeable power (P_{L2}) that does not exceed the upper limit voltage based on the temperature of the battery 1 and the SOC.

After calculating the long-term chargeable power (P_{L1}) and the long-term chargeable power (P_{L2}), the long-term chargeable power calculation unit 7 finally calculates the smaller power as the long-term chargeable power. Thus, while the charge control device 100 according to the embodiment reduces the deposition of lithium, the charge control device 100 can control the charge of the battery 1 so as not to exceed the upper limit voltage of the battery usable voltage range. Note that, similarly to the short-term chargeable power calculation unit 6, the long-term chargeable power calculation unit 7 does not necessarily need to calculate both powers of the long-term chargeable power (P_{L1}) and the long-term chargeable power (P_{L2}), and may calculate any one of the long-term chargeable powers.

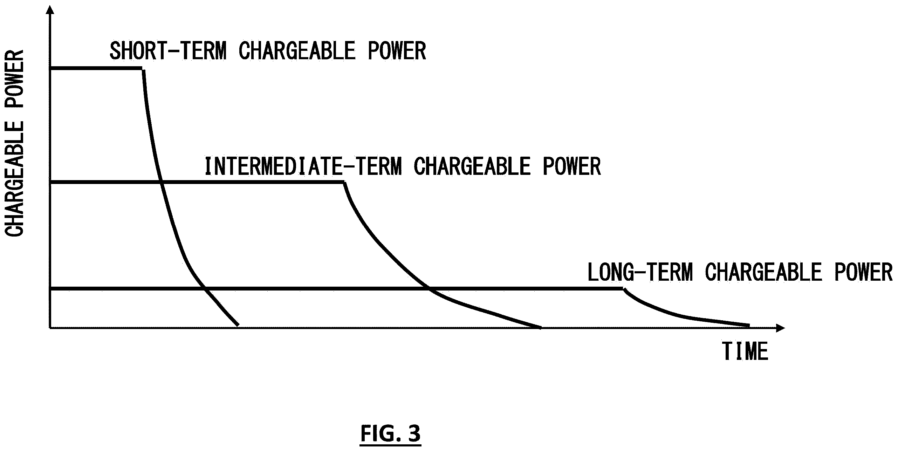

FIG. 3 is a graph illustrating response characteristics of the short-term chargeable power, the intermediate-term chargeable power, and the long-term chargeable power. The graph in FIG. 3 indicates transition of the chargeable powers that transition as a charge time passes when the battery 1 is charged by each power of the short-term chargeable power, the intermediate-term chargeable power, and the long-term chargeable power. With reference to the graph in FIG. 3, a relationship between the short-term/long-term chargeable powers and the charge of the battery is described.

The short-term chargeable power (Pₛ₁ or Pₛ₂) becomes a power generated by the overshooting of the engine rotation speed after starting the engine 30 or a power that is chargeable in a range from several seconds to several tens of seconds or less such that a regenerative charge power during running the vehicle (especially at high speed) can be absorbed. On the other hand, the long-term chargeable power (P_{L1} or P_{L2}) becomes a power that is chargeable within the range from several hundreds of seconds to several tens of minutes such that the charge power required to complete the warming-up of the battery 1 by charge can be ensured. Therefore, the short-term chargeable power is a power larger than the long-term chargeable power. Additionally, the long-term chargeable power is a power that is chargeable for a long term and the short-term chargeable power is a power that is chargeable for a short time shorter than the long term.

When the battery 1 is charged by the short-term chargeable power, the charge time becomes short, and when the battery 1 is charged by the long-term chargeable power, the charge time becomes long. On the other hand, since the use of the short-term chargeable power reduces the chargeable power in a short time, for example, charge cannot be performed when charge is required to absorb the power by regeneration. Additionally, when the battery 1 is charged by the long-term chargeable power, the charge power decreases. Although the charge power has a margin compared with the short-term chargeable power, when the battery 1 is warmed-up by charge, the warming-up takes time.

That is, when the charge of the battery 1 is controlled by the chargeable power of only any one of the short-term chargeable power and the long-term chargeable power, it is difficult to achieve both of having the margin for a power chargeable power to absorb the regenerative power and reduction in the long warming-up time at the same time. Therefore, the charge control device 100 according to the embodiment calculates the chargeable power in combination of the short-term chargeable power and the long-term chargeable power and controls the charge of the battery 1 based on the calculated chargeable power.

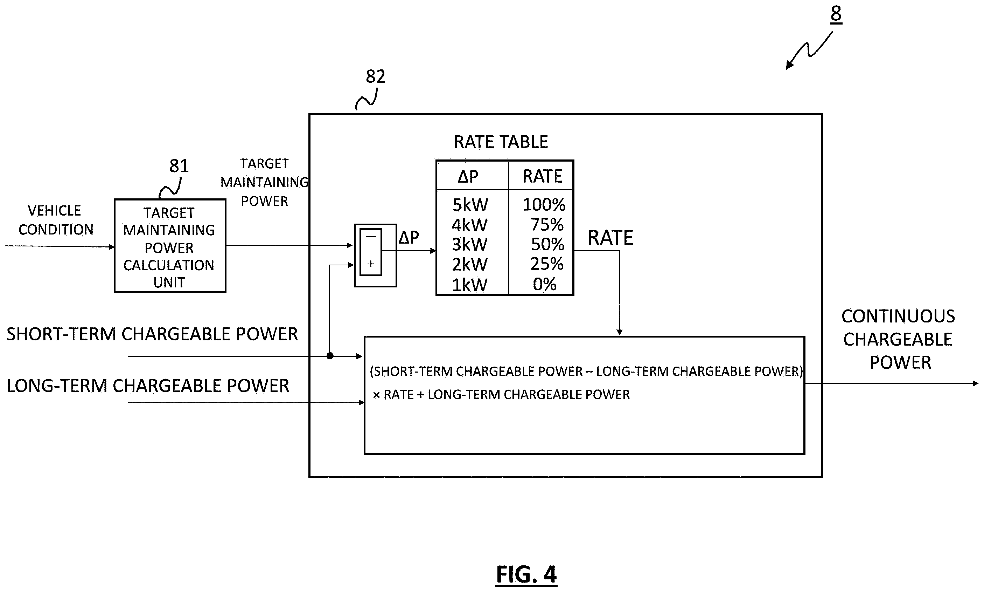

With reference to FIG. 1, the chargeable power calculation unit 8 calculates the continuous chargeable power that is continuously chargeable to the battery 1 based on the short-term chargeable power calculated by the short-term chargeable power calculation unit 6 and the long-term chargeable power calculated by the long-term chargeable power calculation unit 7. FIG. 4 is a block diagram illustrating a function block of the chargeable power calculation unit 8. The chargeable power calculation unit 8 includes a target maintaining power calculation unit 81 and a calculation unit 82. The target maintaining power calculation unit 81 calculates a target maintaining power according to a vehicle condition. The target maintaining power indicates a target value of the chargeable power required to maintain running the vehicle. The vehicle condition is a condition, such as an ON/OFF state of the engine 30 and a vehicle speed. When the engine 30 is in an off state, the target maintaining power calculation unit 81 calculates the chargeable power prepared for starting the engine 30 as the target maintaining power. When the vehicle speed is high, the target maintaining power calculation unit 81 calculates the chargeable power ensured in preparation for later regenerative deceleration as the target maintaining power. The target maintaining power calculated according to the vehicle speed becomes high as the vehicle speed becomes high. That is, the target maintaining power is a target value desired to maintain the short-term chargeable power and is a chargeable power such that the regenerative charge power during running the vehicle and the charge power generated by overshooting of the rotation speed after starting the engine of a series hybrid vehicle can be absorbed.

The calculation unit 82 calculates the continuous chargeable power based on the target maintaining power, the short-term chargeable power, and the long-term chargeable power. First, the calculation unit 82 subtracts the target maintaining power from the short-term chargeable power to calculate a power difference (ΔP). The calculation unit 82 has a rate table that determines a use rate (rate) between the short-term chargeable power and the long-term chargeable power. As illustrated in FIG. 4, the rate table is a table making the power difference (ΔP) correspond to the use rate (rate). For example, when the power difference (ΔP) is 5 kW, the use rate (rate) becomes 100%, the smaller the power difference (ΔP) is, the lower the use rate (rate) becomes, and when the power difference (ΔP) is 1 kW, the use rate (rate) becomes 0%. In the example of the rate table in FIG. 4, when the power difference (ΔP) decreases by 1 kW from 5 kw, the use rate (rate) decreases by 25%. For example, when the deterioration of the battery 1 proceeds, the short-term chargeable power becomes smaller than the target maintaining power, and the power difference (ΔP) becomes zero or negative, the use rate (rate) becomes 0%.

Next, the calculation unit 82 calculates the continuous chargeable power by the following formula (2).
[Math. 2] Continuous chargeable power = (short-term chargeable power - long-term chargeable power) × rate + long-term chargeable power

Thus, the chargeable power calculation unit 8 calculates the target maintaining power, calculates the rate between the short-term chargeable power and the long-term chargeable power according to the difference between the short-term chargeable power and the target maintaining power, and calculates the continuous chargeable power according to the calculated rate.

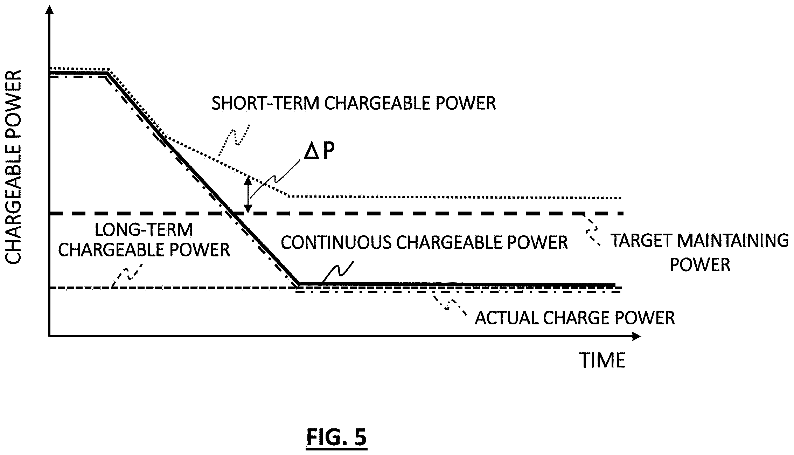

FIG. 5 illustrates response of the chargeable power in a timing chart. FIG. 5 is a graph illustrating characteristics of the short-term/long-term chargeable powers, the target maintaining power, an actual charge power, and the continuous chargeable power. As illustrated in FIG. 5, when the short-term chargeable power has a margin for the target maintaining power, that is, when the power difference (ΔP) is large, the rate of the short-term chargeable power is increased and continuous chargeable power is calculated. In FIG. 5, when the difference between the short-term chargeable power and the target maintaining power is large (ΔP ≥ 5 kW), in the continuous chargeable power, the use rate of the short-term chargeable power becomes 100%. When the short-term chargeable power decreases and the power difference (ΔP) decreases (1 kW < ΔP < 5 kW), the smaller the power difference (ΔP) becomes, the lower the use rate of the short-term chargeable power becomes. Therefore, when the short-term chargeable power decreases in the timing chart as illustrated in FIG. 5, a continuous chargeable power lowers at a decrease rate larger than the short-term chargeable power. When the short-term chargeable power further decreases and the power difference (ΔP) decreases (ΔP ≤ 1 kW), the use rate of the short-term chargeable power becomes 0% and the continuous chargeable power matches the long-term chargeable power.

Thus, when the short-term chargeable power has the margin for the target maintaining power, the chargeable power calculation unit 8 calculates the continuous chargeable power such that the rate of the short-term chargeable power increases. On the other hand, when the short-term chargeable power does not have the margin for the target maintaining power, the chargeable power calculation unit 8 calculates the continuous chargeable power such that the rate of the long-term chargeable power increases. Thus, when the short-term chargeable power has the margin for the target maintaining power, charge is performed to ensure promoting the warming-up of the battery. Additionally, when there is no margin, suppressing the charge power allows maintaining the state in which the short-term chargeable power becomes the target maintaining power or more.

With reference to FIG. 1, the vehicle controller 20 has a function of controlling the charge/discharge of the battery 1 and a function of controlling the drive system while managing the state of the battery 1. The vehicle controller 20 transmits a torque command to the engine 30 and a rotation speed command to the electric generator 40 to generate a power and charge the battery 1. Additionally, the vehicle controller 20 transmits the torque command to the motor/inverter 50 to generate a driving power required for running the vehicle. To charge the battery 1, the vehicle controller 20 restricts the upper limit of the charge power of the battery 1 to the continuous chargeable power calculated by the chargeable power calculation unit 8 and charges the battery 1.

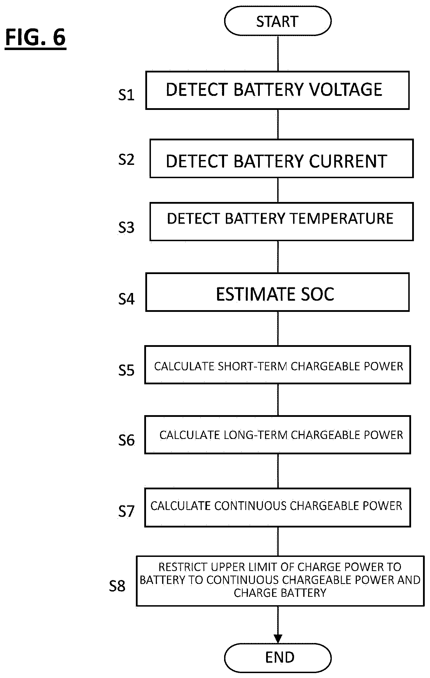

Next, with reference to FIG. 6, a control flow of the charge control method performed by a processor included in the charge control device 100 is described. FIG. 6 is the flowchart of the charge control method. Note that each step does not necessarily need to be performed in the order depicted in FIG. 6 and the order may be changed as necessary. At Step S1, the voltage detection unit 2 detects the voltage of the battery 1. At Step S2, the current detection unit 3 detects the current of the battery 1. At Step S3, the temperature detection unit 4 detects the temperature of the battery 1. At Step S4, the SOC estimation unit 5 estimates the SOC based on the voltage and the current of the battery 1. For example, the SOC estimation unit 5 uses an SOC obtained from an average voltage of the battery 1 at starting the vehicle as an initial value and integrates the current flowing through the battery 1 to estimate the SOC of the battery 1.

At Step S5, the short-term chargeable power calculation unit 6 calculates the short-term chargeable power based on the temperature of the battery 1 and the SOC. At Step S6, the long-term chargeable power calculation unit 7 calculates the long-term chargeable power based on the temperature of the battery 1 and the SOC. At Step S7, the chargeable power calculation unit 8 calculates the continuous chargeable power based on the short-term chargeable power, the long-term chargeable power, and the target maintaining power. At Step S8, the vehicle controller 20 restricts the upper limit of the charge power to the battery 1 to the continuous chargeable power and controls the charge of the battery 1.

As described above, the charge control method and the charge control device according to the embodiment calculate the long-term chargeable power, calculate the short-term chargeable power larger than the long-term chargeable power, calculate the continuous chargeable power based on the short-term chargeable power and the long-term chargeable power, and restrict the upper limit of the charge power of the battery 1 to the continuous chargeable power. Thus, the power generated according to the running scene of the vehicle can be absorbed by the battery. Additionally, a shortage of the chargeable power during the cryogenic temperature can be reduced, regenerative charge during vehicle deceleration can be ensured, and running the vehicle can be maintained.

As the characteristics of the lithium-ion battery, when the battery temperature is low, the chargeable power decreases. Therefore, as the charge control method of the battery 1, decreasing the chargeable power as the battery temperature lowers has been conventionally performed. However, with the method of decreasing the chargeable power depending on only the battery temperature, the chargeable power becomes minute during a low temperature, and there is a problem that is it difficult to absorb the charge by the regenerative power during running the vehicle and the power generated by overshooting of the rotation speed after starting the engine of the series hybrid vehicle by the battery. Especially, when low temperature performance is inferior due to the deterioration of the battery 1, the chargeable power during a low temperature is further reduced and this problem becomes more remarkable.

The charge control according to the embodiment calculates the short-term chargeable power, calculates the long-term chargeable power, calculates the continuous chargeable power in combination with the short-term chargeable power and the long-term chargeable power, restricts the upper limit of the charge power of the battery to the continuous chargeable power, and performs the battery charge control in the vehicle drive system. This allows absorbing the power generated according to the running scene of the vehicle by the battery.

The charge control method and the charge control device according to the embodiment calculate the target maintaining power, calculate the rate between the short-term chargeable power and the long-term chargeable power according to a difference between the short-term chargeable power and the target maintaining power, and calculate the continuous chargeable power according to the rate. Thus, when there is a margin for a short-term chargeable power, by calculating the continuous chargeable power such that the rate of the short-term chargeable power increases, the charge power can be significantly ensured and the warming-up of the battery is promoted. On the other hand, when there is no margin for the short-term chargeable power, by calculating the continuous chargeable power such that a rate of a long-term chargeable power increases, absence of the chargeable power can be reduced, and running the vehicle can be maintained. Additionally, the short-term chargeable power can be maintained to be the target power or more, the power generated by the overshooting of the rotation speed at the start of the engine of the series hybrid vehicle can be absorbed by the battery, and running the vehicle can be maintained.

The charge control method and the charge control device according to the embodiment calculate the short-term chargeable power and the long-term chargeable power based on the upper limit current at which the lithium is not deposited. Thus, the deterioration of the battery and the decrease in performance can be suppressed and the life can be extended. When the upper limit of the charge power of the battery 1 is restricted to be the continuous chargeable power, the charging current of the battery 1 can be suppressed to the upper limit current or less, and therefore the deposition of the lithium of the battery can be reduced.

Additionally, the charge control method and the charge control device according to the embodiment calculate the short-term chargeable power and the long-term chargeable power based on the usable upper limit voltage of the battery 1. Thus, the deterioration of the battery and the decrease in performance can be suppressed and the life can be extended. When the upper limit of the charge power of the battery 1 is restricted to be the continuous chargeable power, the charging voltage of the battery 1 can be suppressed to the upper limit voltage or less, and therefore the overcharge of the battery can be reduced.

The charge control method and the charge control device according to the embodiment detect the temperature of the battery 1, calculate the SOC of the battery 1, and calculate the upper limit current based on the temperature and the SOC. Thus, the deterioration of the battery and the decrease in performance can be suppressed and the life can be extended.

The charge control method and the charge control device according to the embodiment detect the temperature of the battery 1, calculate the SOC of the battery 1, and calculate the short-term chargeable power and the long-term chargeable power not exceeding the upper limit voltage based on the temperature and the SOC. Thus, the deterioration of the battery and the decrease in performance can be suppressed and the life can be extended.

### <<Second Embodiment>>

Next, a charge control device and a charge control method according to the second embodiment are described. In the second embodiment, a deterioration rate estimation unit 9 and an upper limit SOC calculation unit 10 are provided in the first embodiment. Note that, except that points described below are different from the charge control device and the charge control method according to the first embodiment, a configuration similar to the first embodiment is provided, an operation or an action are similar to the first embodiment, and the description in the first embodiment is appropriately cited. In the embodiment, in addition to the condition of the chargeable power for restricting the upper limit of the charge power of the battery 1 to the continuous chargeable power, the upper limit SOC is set, and when the SOC reaches the upper limit SOC during the charge of the battery 1, the charge of the battery 1 is controlled.

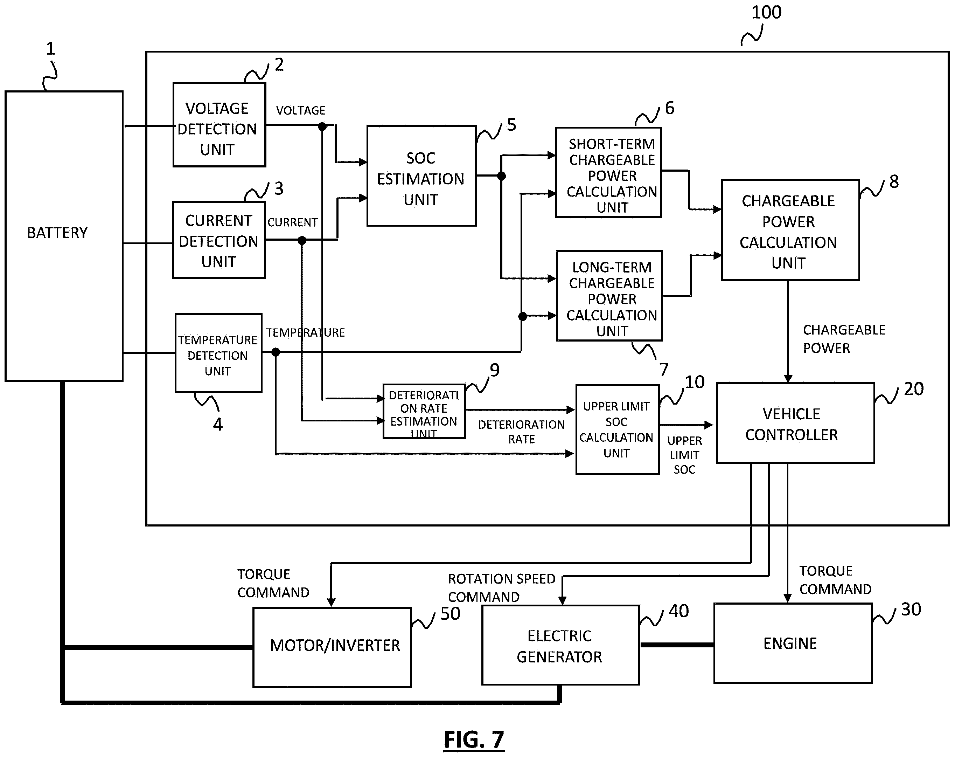

FIG. 7 is a block diagram illustrating a drive system according to another embodiment of the present invention. The charge control device 100 includes the deterioration rate estimation unit 9 and the upper limit SOC calculation unit 10 in addition to the voltage detection unit 2 and the like. The deterioration rate estimation unit 9 divides a present value of the internal resistance of the battery 1 by an initial value of the internal resistance of the battery 1 to estimate the deterioration rate of the battery 1. The initial value of the internal resistance is an internal resistance of a new product of a battery.

The upper limit SOC calculation unit 10 calculates the upper limit SOC based on the temperature of the battery 1 and the deterioration rate. The upper limit SOC indicates the upper limit value of the chargeable SOC of the battery 1. The upper limit SOC calculation unit 10 calculates the upper limit SOC such that the short-term chargeable power becomes the target maintaining power or more.

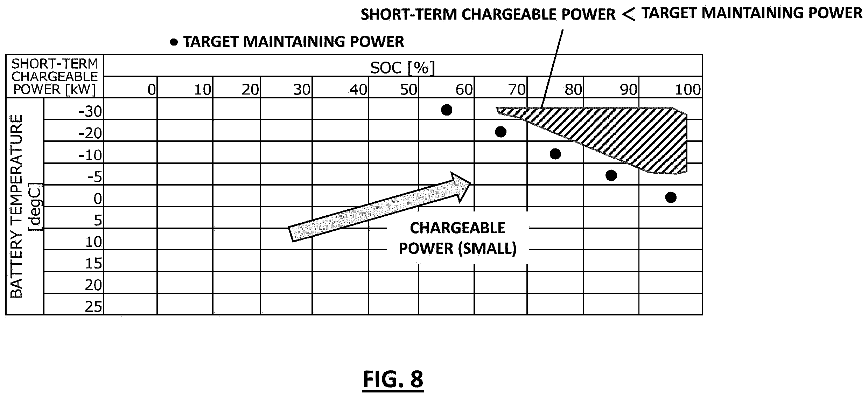

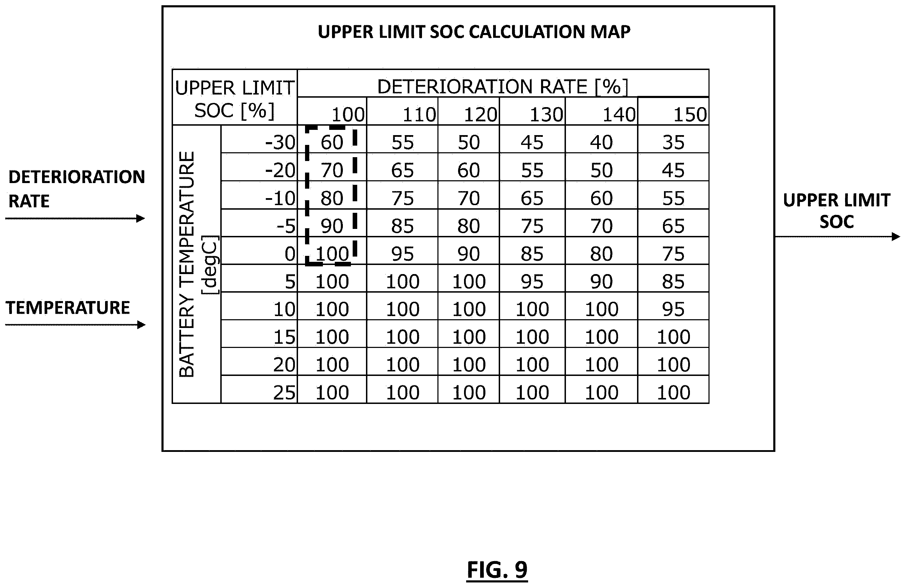

With reference to FIG. 8 and FIG. 9, an upper limit SOC calculation method is described. FIG. 8 is a table for describing a correlation between the battery temperature, the SOC, the short-term chargeable power, and the target maintaining power. FIG. 9 is a conceptual diagram of a map stored in the upper limit SOC calculation unit 10.

As the characteristics of the battery 1, the lower the temperature of the battery 1 is, the smaller the short-term chargeable power becomes, and the higher the SOC is, the smaller the short-term chargeable power becomes. Therefore, in a low-temperature region of the battery 1, when the SOC becomes high, the short-term chargeable power falls below the target maintaining power. For example, as illustrated in FIG. 8, in a case where the temperature of the battery 1 is -30 [degC], when the SOC is higher than 60%, the short-term chargeable power becomes less than the target maintaining power. Thus, in a state where the SOC is high and the short-term chargeable power is smaller than the target maintaining power, when the start of the engine is necessary or when the regenerative deceleration is necessary during high speed running, the power generated by the overshooting of the engine rotation speed or the regenerative power during the regenerative deceleration possibly cannot be charged by the battery 1.

In the embodiment, within the range in which the short-term chargeable power becomes less than the target maintaining power, the upper limit SOC is set from the temperature of the battery 1 and the condition of the SOC, and the charge is restricted such that the short-term chargeable power does not become less than the target maintaining power. Specifically, the upper limit SOC calculation unit 10 has a map (an upper limit SOC calculation map) as illustrated in FIG. 9 in which the temperature of the battery 1, the deterioration rate, and the upper limit SOC correspond to one another and calculates the upper limit SOC using the map. The upper limit SOC calculation map is a map for calculating the upper limit SOC with the temperature of the battery 1 and the deterioration rate as inputs. In the SOC calculation map, in a low temperature region of the temperature of the battery 1 (for example, a region of the temperature of less than 0 degC with the deterioration rate of 100% (a state similar to the new product)), the lower the battery temperature is, the smaller the upper limit SOC becomes. The upper limit SOC of the part surrounded by the dotted line frame in FIG. 9 corresponds to the target maintaining power in FIG. 8. That is, when the deterioration rate is 100% and the temperature of the battery 1 is -30 [degC], restricting the upper limit SOC to 60% reduces the short-term chargeable power being less than the target charge power.

Additionally, in a temperature region in which the upper limit SOC is restricted to be less than 100% according to the battery temperature, as the deterioration of the battery 1 proceeds, the temperature region gradually expands to a high temperature side, and further the upper limit SOC lowers. Since the deterioration of the battery 1 increases the internal resistance and decreases the chargeable power, each of the deterioration rates is made to correspond to the battery temperature and the upper limit SOC and the relationship between the battery temperature and the upper limit SOC is set on the map. Thus, the upper limit SOC is set in the upper limit SOC calculation map such that the short-term chargeable power becomes the target maintaining power or more. Note that the values of FIG. 9 are one example and are changeable as necessary according to the characteristics of the battery 1 and the like.

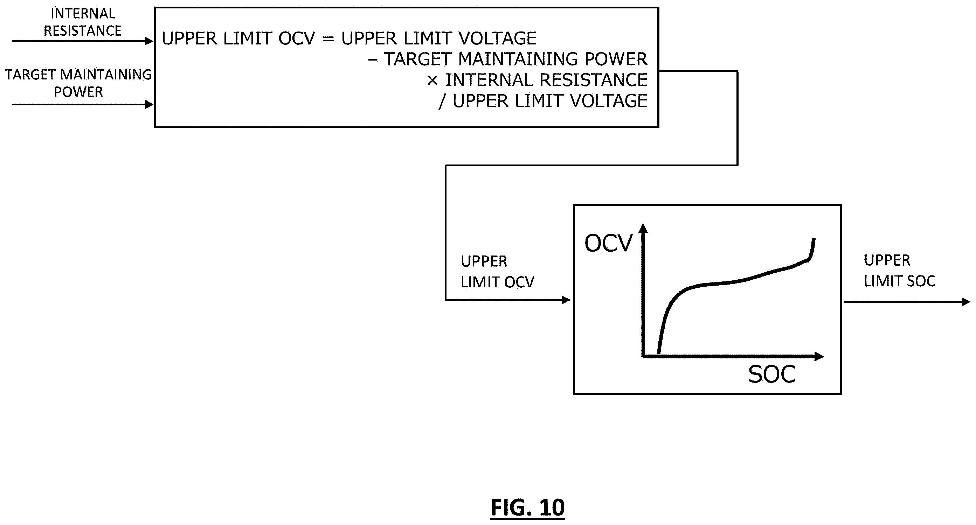

The upper limit SOC calculation unit 10 may calculate the upper limit SOC in the following manner besides the above-described calculation method using the upper limit SOC calculation map. FIG. 10 is a block diagram illustrating a control flow of the upper limit SOC calculation method by the upper limit SOC calculation unit 10.

As indicated in the formula (1) of the first embodiment, the target maintaining power is calculated from the upper limit voltage, the internal resistance, and the OCV. In the formula (1), when the OCV is replaced by the upper limit OCV, the following formula (3) is derived.
[Math. 3] Target maintaining power = (upper limit voltage - upper limit OCV)/internal resistance × upper limit voltage

Furthermore, the formula (3) is expanded to derive the following formula (4) to obtain the upper limit SOC.
[Math. 4] Upper limit OCV = upper limit voltage - target maintaining power × internal resistance/upper limit voltage

The target maintaining power is determined by a vehicle condition. The upper limit voltage is preliminarily determined by a usable voltage range according to the characteristics of the battery 1. The internal resistance is calculated from the present current/voltage of the battery 1. Therefore, assigning these parameters for the formula (4) allows calculating the upper limit OCV. Further, as illustrated in FIG. 10, the upper limit SOC calculation unit 10 refers to the relationship table between the OCV and the SOC and calculates the SOC corresponding to the calculated upper limit OCV as the upper limit SOC. Thus, the upper limit SOC calculation unit 10 calculates the upper limit OCV at which the short-term chargeable power becomes the predetermined power or more based on the upper limit voltage, the target maintaining power, and the internal resistance, and calculates the upper limit SOC corresponding to the upper limit OCV.

With reference to FIG. 7, the vehicle controller 20 acquires the upper limit SOC from the upper limit SOC calculation unit 10, restricts the upper limit of the SOC of the battery 1 to the upper limit SOC, and charges the battery 1.

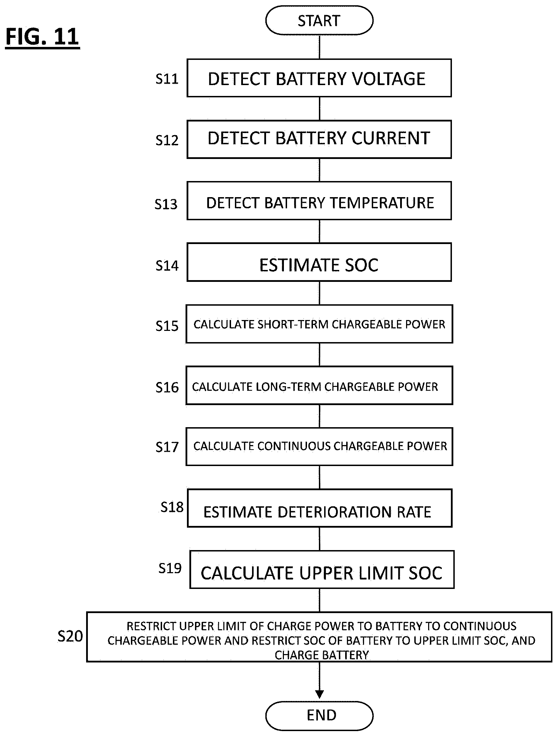

Next, with reference to FIG. 11, the control flow of the charge control method by the charge control device 100 is described. FIG. 11 is a flowchart of the charge control method. Note that each step does not necessarily need to be performed in the order depicted in FIG. 11 and the order may be changed as necessary. Since the control flow of Steps S1 1 to S17 is the same content as Steps S1 to S7 of the first embodiment, the description is omitted.

At Step S18, the deterioration rate estimation unit 9 estimates the deterioration rate of the battery from the average voltage and the current of the battery 1. At Step S19, the upper limit SOC calculation unit 10 calculates the upper limit SOC such that the short-term chargeable power becomes the target maintaining power or more based on the temperature of the battery 1 and the deterioration rate. At Step S20, the vehicle controller 20 restricts the upper limit of the charge power to the battery 1 to the continuous chargeable power, restricts the SOC of the battery 1 to the upper limit SOC, and controls the charge of the battery 1.

As described above, the charge control method and the charge control device according to the embodiment detect the temperature of the battery 1, calculate the deterioration rate of the battery 1, calculate the upper limit SOC of the battery 1 based on the temperature and the deterioration rate, restrict the SOC of the battery 1 to the upper limit SOC, and charge the battery 1. By thus setting the upper limit of the SOC, the chargeable power can be ensured and running the vehicle can be maintained. Additionally, since the battery 1 has characteristics of reducing the chargeable power by the increase in the SOC, by setting the upper limit SOC during the charge according to the temperature and the deterioration rate of the battery, the chargeable power can be ensured while the deterioration of the battery 1 is considered.

Additionally, the charge control method and the charge control device according to the embodiment have the map in which the temperature of the battery 1, the deterioration rate, and the upper limit SOC correspond to one another and calculate the upper limit SOC using the map. Additionally, the upper limit SOC is set in the map such that the short-term chargeable power becomes the target maintaining power or more. By thus setting the upper limit of the SOC, the chargeable power can be ensured and running the vehicle can be maintained.

The charge control method and the charge control device according to the embodiment estimate the internal resistance of the battery, calculate the upper limit OCV such that the short-term chargeable power becomes the predetermined power (equivalent to the target maintaining power) or more based on the usable upper limit voltage of the battery 1, the target maintaining power, and the internal resistance, calculate the upper limit SOC corresponding to the upper limit OCV, restrict the SOC of the battery to the upper limit SOC, and charge the battery. By thus setting the upper limit of the SOC, the chargeable power can be ensured and running the vehicle can be maintained.

### <<Third Embodiment>>

Next, a charge control device and a charge control method according to the third embodiment are described. In the third embodiment, a warming-up determination unit 11 is provided in the first embodiment. Note that, except that points described below are different from the charge control device and the charge control method according to the first embodiment, a configuration similar to the first embodiment is provided, an operation or an action are similar to the first embodiment, and the description in the first embodiment and/or the second embodiment are appropriately cited. In the embodiment, the deterioration rate estimation unit 9 and the upper limit SOC calculation unit 10 may be added, and the battery 1 may be controlled under the control described in the second embodiment.

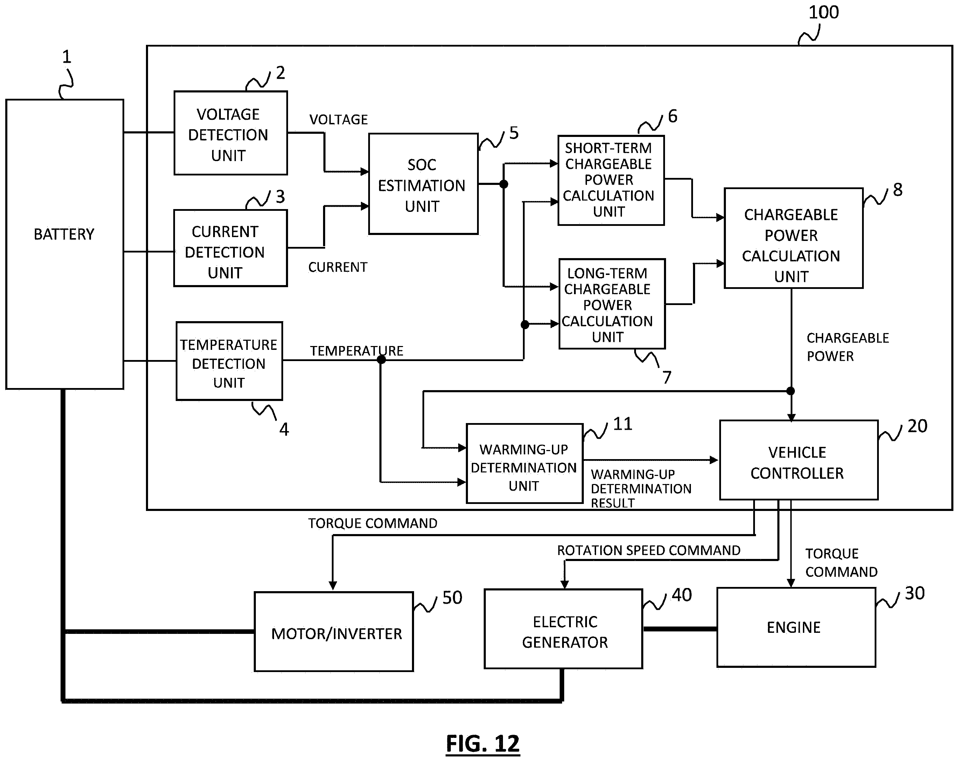

FIG. 12 is a block diagram illustrating a drive system according to another embodiment of the present invention. The charge control device 100 includes the warming-up determination unit 11 in addition to the voltage detection unit 2 and the like. The warming-up determination unit 11 determines whether or not the warming-up of the battery 1 is completed based on the temperature of the battery 1 detected by the temperature detection unit 4 and the chargeable power calculated by the chargeable power calculation unit 8 and outputs the warming-up determination result to the vehicle controller 20.

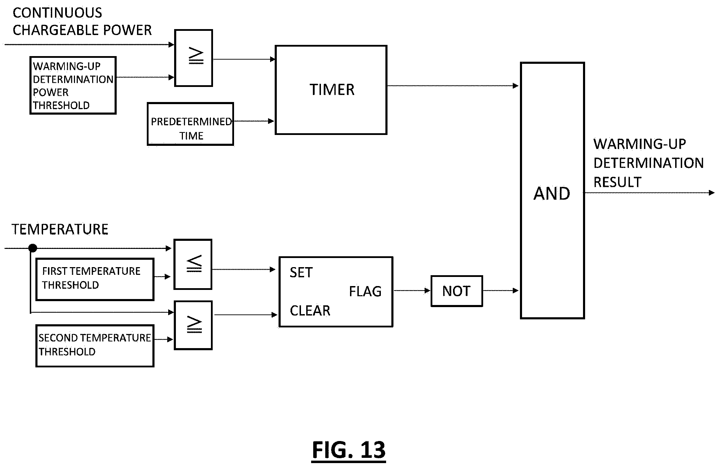

With reference to FIG. 13, a warming-up determination method is described. FIG. 13 is a block diagram illustrating a control flow of the warming-up determination method by the warming-up determination unit 11. The warming-up determination unit 11 performs warming-up determination using the chargeable power condition and the temperature condition. When the two conditions are met, the warming-up determination unit 11 determines that the warming-up is completed. When the two conditions are not met, the warming-up determination unit 11 determines that the warming-up is not completed. The warming-up determination unit 11 performs the determination on the completion of warming-up after the start of warming-up by charging the battery 1.

A warming-up determination power threshold is a threshold indicating that the chargeable power required for the warming-up can be ensured when the battery 1 is warmed-up by charging the battery 1. The warming-up determination power threshold is a preliminarily set threshold and is set to a power higher than the target maintaining power. The warming-up determination power threshold is a threshold set such that the short-term chargeable power does not fall below the target maintaining power again after the warming-up completion determination.

When a timer measures a state in which the continuous chargeable power is higher than the warming-up determination power threshold and the measurement time (count) is a predetermined time, the warming-up determination unit 11 determines that the chargeable power condition is met. On the other hand, when the continuous chargeable power is lower than the warming-up determination power threshold or a duration (the measurement time) in a state in which the continuous chargeable power is higher than the warming-up determination power threshold is less than the predetermined time, the warming-up determination unit 11 determines that the chargeable power condition is not met.

The warming-up determination unit 11 has a temperature threshold having a hysteresis including a first temperature threshold and a second temperature threshold as the temperature condition. The second temperature threshold is higher than the first temperature threshold. The warming-up determination unit 11 compares the temperature of the battery 1 with the first/second temperature thresholds. When the temperature of the battery 1 is the first temperature threshold or less, a flag indicating that warming-up is being performed is raised (set). When the temperature of the battery 1 is the first temperature threshold or more and less than the second temperature threshold, the flag is in the set state (set). When the temperature of the battery 1 becomes the second temperature threshold or more, the flag is in a clear state (clear). The warming-up determination unit 11 performs NOT calculation on the state of the flag, and when the flag is not in the set state, the warming-up determination unit 11 determines that the temperature condition for the warming-up completion determination is met. When the flag is in the set state, the warming-up determination unit 11 determines that the warming-up is being performed and the temperature condition for the warming-up completion determination is not met.

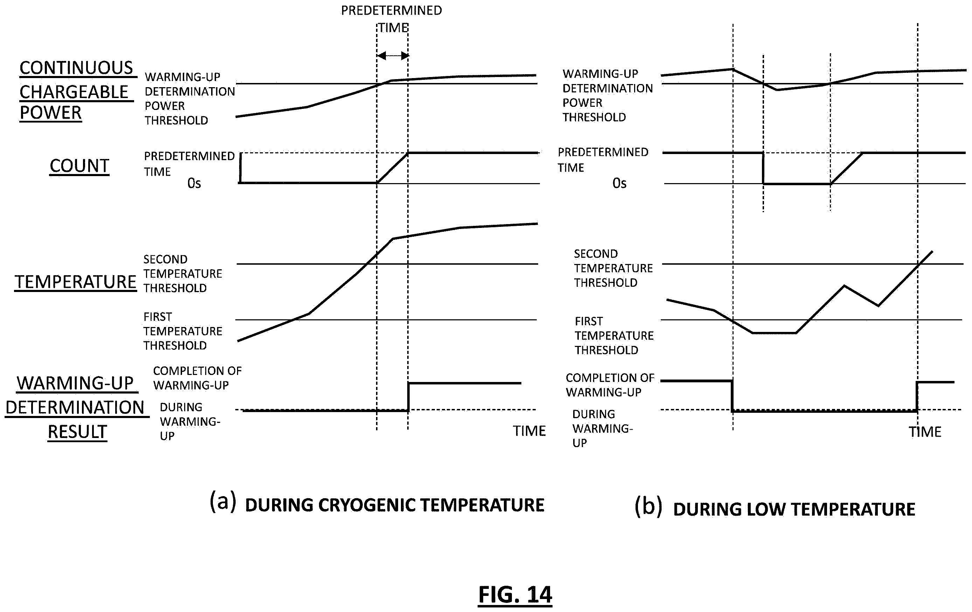

FIG. 14 illustrates a timing chart of various parameters related to the warming-up determination and the warming-up determination result. FIG. 14(a) illustrates a timing chart during a cryogenic temperature and FIG. 14(b) illustrates a timing chart during a low temperature. With reference to FIG. 14(a), during the cryogenic temperature, the temperature of the battery 1 starts from a state of less than the first temperature threshold and the warming-up is being performed. The temperature of the battery 1 gradually increases by the warming-up. When the continuous chargeable power increases and becomes the warming-up determination power threshold or more, count by the timer starts. When the temperature of the battery 1 becomes the second temperature threshold or more and the count reaches the predetermined time, the warming-up determination unit 11 determines completion of the warming-up.

At the low temperature, the temperature of the battery 1 starts from a state of the first temperature threshold or more and warming-up does not start. When the temperature of the battery 1 decreases and becomes less than the first temperature threshold, the vehicle controller 20 starts warming-up. The warming-up determination unit 11 determines that warming-up is being performed. During the warming-up, when a continuous chargeable power is reduced and becomes less than a warming-up determination power threshold, the warming-up determination unit 11 resets the count by the timer. Afterwards, when the continuous chargeable power becomes the warming-up determination power threshold or more, the warming-up determination unit 11 starts the count by the timer. In the example of FIG. 14(b), before the temperature of the battery 1 reaches the second temperature threshold, the count reaches the predetermined time, and the warming-up determination unit 11 determines that a chargeable power condition is met. Afterwards, when the temperature of the battery 1 becomes high and reaches the second temperature threshold, the warming-up determination unit 11 determines that a temperature condition is met in addition to the chargeable power condition to determine the completion of the warming-up.

With reference to FIG. 12, when the warming-up determination unit 11 determines that the warming-up is being performed, the vehicle controller 20 restricts the upper limit of the charge power of the battery 1 to the continuous chargeable power. When the warming-up determination unit 11 determines the completion of warming-up, the vehicle controller 20 restricts the upper limit of the charge power to a usual chargeable power, for example, the short-term chargeable power or the intermediate-term chargeable power, etc. The intermediate-term chargeable power is a power that is chargeable in a time between the short term and the long term (equivalent to the "intermediate-term chargeable power" in FIG. 3).

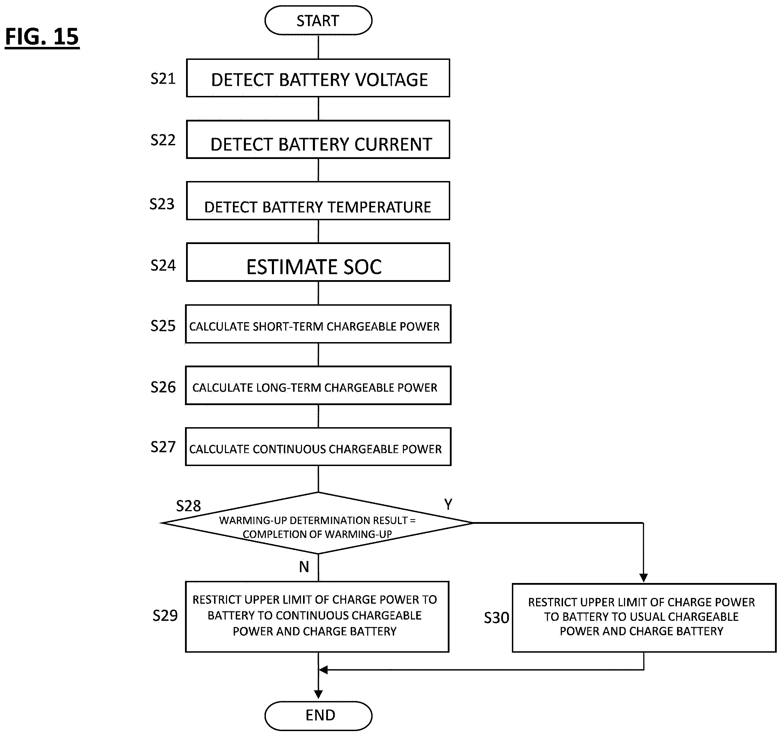

Next, with reference to FIG. 15, the control flow of the charge control method by the charge control device 100 is described. FIG. 15 is a flowchart of the charge control method. The control flow in FIG. 15 is a flow performed during the warming-up of the battery 1. Note that each step does not necessarily need to be performed in the order depicted in FIG. 15 and the order may be changed as necessary. Since the control flow of Steps S21 to S27 is the same content as Steps S1 to S7 of the first embodiment, the description is omitted.

At Step S28, the warming-up determination unit 11 determines whether or not the warming-up of the battery 1 is completed based on the temperature of the battery 1 detected by the temperature detection unit 4 and the chargeable power calculated by the chargeable power calculation unit 8. When it is determined that the warming-up is not completed, at Step S29, the vehicle controller 20 restricts the upper limit of the charge power to the battery 1 to the continuous chargeable power and controls the charge of the battery 1. When it is determined that the warming-up is completed, the vehicle controller 20 restricts the upper limit of the charge power to the battery 1 to the usual chargeable power and controls the charge of the battery 1(S30).

As described above, the charge control method and the charge control device according to the embodiment determine whether or not the warming-up of the battery 1 is completed based on the temperature of the battery 1 and the continuous chargeable power. By thus determining the warming-up completion of the battery, it can be switched to usual chargeable power calculation.

Note that the embodiments described above are described for ease of understanding of the present invention and are not described to limit the present invention. Accordingly, each element disclosed in the above-described embodiment is intended to include all design changes and equivalents that fall within the technical scope of the present invention.

### Description of Reference Numerals

- 1: Battery
- 2: Voltage detection unit
- 3: Current detection unit
- 4: Temperature detection unit
- 5: SOC estimation unit
- 6: Short-term chargeable power calculation unit
- 7: Long-term chargeable power calculation unit
- 8: Chargeable power calculation unit
- 9: Deterioration rate estimation unit
- 10: Upper limit SOC calculation unit
- 11: Warming-up determination unit
- 20: Vehicle controller
- 30: Engine
- 40: Electric generator
- 50: Motor/inverter
- 100: Charge control device

## Claims

1. A charge control method that controls charge of a battery performed by a processor, the battery including a lithium-ion battery and disposed in a vehicle, wherein the processor:
calculates a long-term chargeable power as a power that allows charging the battery for a long term;
calculates a short-term chargeable power as a power that allows charging the battery for a short term and is larger than the long-term chargeable power;
calculates a continuous chargeable power that allows continuously charging the battery based on the short-term chargeable power and the long-term chargeable power; and
restricts an upper limit of a charge power of the battery to the continuous chargeable power.

2. The charge control method according to claim 1, wherein the processor:
calculates a target maintaining power indicating a target value of a chargeable power required to maintain running the vehicle;
calculates a rate between the short-term chargeable power and the long-term chargeable power according to a difference between the short-term chargeable power and the target maintaining power; and
calculates the continuous chargeable power according to the rate.

3. The charge control method according to claim 1 or 2, wherein
the processor calculates the short-term chargeable power and the long-term chargeable power based on an upper limit current at which lithium is not deposited.

4. The charge control method according to any one of claims 1 to 3, wherein
the processor calculates the short-term chargeable power and the long-term chargeable power based on an upper limit voltage usable of the battery.

5. The charge control method according to claim 3, wherein
the processor:
detects a temperature of the battery;
calculates an SOC of the battery; and
calculates the upper limit current based on the temperature and the SOC.

6. The charge control method according to claim 4, wherein
the processor:
detects a temperature of the battery;
calculates an SOC of the battery; and
calculates the short-term chargeable power and the long-term chargeable power not exceeding the upper limit voltage based on the temperature and the SOC.

7. The charge control method according to any one of claims 1 to 4, wherein
the processor:
detects a temperature of the battery;
calculates a deterioration rate of the battery;
calculates an upper limit SOC of an SOC that allows charging the battery based on the temperature and the deterioration rate; and
restricts the SOC of the battery to the upper limit SOC and charges the battery.

8. The charge control method according to claim 7, wherein
the processor:
has a map in which the temperature, the deterioration rate, and the upper limit SOC correspond to one another; and
calculates the upper limit SOC using the map, wherein
the upper limit SOC is set in the map such that the short-term chargeable power becomes a target maintaining power or more, and
the target maintaining power indicates a target value of a chargeable power required to maintain running the vehicle.

9. The charge control method according to any one of claims 1 to 4, wherein
the processor:
estimates an internal resistance of the battery;
calculates an upper limit OCV at which the short-term chargeable power becomes a predetermined power or more, based on an upper limit voltage usable of the battery, a target maintaining power indicating a target value of a chargeable power required to maintain running the vehicle including the battery, and the internal resistance;
calculates an upper limit SOC corresponding to the upper limit OCV; and
restricts an SOC of the battery to the upper limit SOC and charges the battery.

10. The charge control method according to any one of claims 1 to 4, wherein
the processor:
detects a temperature of the battery; and
determines whether or not warming-up of the battery is completed based on the temperature and the continuous chargeable power.

11. A charge control device including a controller that controls charge of a battery, the battery including a lithium-ion battery and disposed in a vehicle, wherein
the controller:
calculates a long-term chargeable power as a power that allows charging the battery for a long term;
calculates a short-term chargeable power as a power that allows charging the battery for a short term and is larger than the long-term chargeable power;
calculates a continuous chargeable power that allows continuously charging the battery based on the short-term chargeable power and the long-term chargeable power; and
restricts an upper limit of a charge power of the battery to the continuous chargeable power.
